# FASCICULE DE BREVET EUROPEEN

(11) **EP 1 344 258 B1**
(45) Date de publication et mention de la délivrance du brevet: **17.01.2007**
(21) Numéro de dépôt: 01993939.6
(22) Date de dépôt: 06.11.2001
(51) Int. Cl.: H01L 31/0203

(54) **DISPOSITIF DE DETECTION DE RAYONNEMENTS ELECTROMAGNETIQUES TRIDIMENSIONNEL ET PROCEDE DE REALISATION DE CE DISPOSITIF**
DREIDIMENSIONALER ELEKTROMAGNETISCHER STRAHLUNGSDETEKTOR UND DESSEN VERFAHREN ZUR HERSTELLUNG
DEVICE FOR DETECTING THREE-DIMENSIONAL ELECTROMAGNETIC RADIATION AND METHOD FOR MAKING SAME

(30) Priorité: 07.11.2000 FR 0014247
(43) Date de publication de la demande: 17.09.2003
(73) Titulaire: COMMISSARIAT A L'ENERGIE ATOMIQUE, 75015 Paris (FR)
(72) Inventeur: OUVRIER-BUFFET, Jean-Louis, F-74320 SEVRIER (FR); BISOTTO, Sylvette, F-38000 GRENOBLE (FR); CAPLET, Stéphane, F-38360 SASSENAGE (FR)
(74) Mandataire: Poulin, Gérard
(86) Numéro de dépôt international: PCT/FR2001/003422
(87) Numéro de publication internationale: WO 2002/039481

(56) Documents cités:
- WO-A-95/17014
- WO-A-99/67818
- PATENT ABSTRACTS OF JAPAN vol. 2000, no. 13, 5 février 2001 (2001-02-05) -& JP 2000 298063 A (TDK CORP), 24 octobre 2000 (2000-10-24)
- PATENT ABSTRACTS OF JAPAN vol. 1999, no. 10, 31 août 1999 (1999-08-31) -& JP 11 145489 A (MATSUSHITA ELECTRIC IND CO LTD), 28 mai 1999 (1999-05-28)
- PATENT ABSTRACTS OF JAPAN vol. 1998, no. 02, 30 janvier 1998 (1998-01-30) -& JP 09 264784 A (TERUMO CORP;KIMURA MITSUTERU), 7 octobre 1997 (1997-10-07)

## Description

### Domaine de l'invention

L'invention concerne un dispositif de détection de rayonnements électromagnétiques, comme des rayonnements infrarouges, dans lequel les détecteurs et le circuit de lecture sont insérés dans une cavité sous vide, fermée par une fenêtre transparente aux rayonnements électromagnétiques, permettant des connexions électriques étanches vers l'extérieur.

L'invention concerne aussi un procédé de réalisation de ce dispositif.

L'invention se rapporte au domaine des détecteurs thermiques et, en particulier, des détecteurs infrarouges thermiques n'on refroidis. Elle peut être utilisée, par exemple, dans des imageurs infrarouges monolithiques fonctionnant à température ambiante, et fabriqués à partir d'une matrice d'éléments sensibles connectée à un circuit de multiplexage en silicium de type CMOS ou CCD.

### Etat de la technique

Les détecteurs thermiques non refroidis comportent généralement un élément sensible pouvant être chauffé par un rayonnement infrarouge dans la bande 8 à 12 µm, cet élément sensible étant caractéristique de la température et de l'émissivité des corps observés. L'augmentation de température de l'élément sensible engendre une .variation d'une propriété électrique du matériau sensible ; cette propriété peut être, par exemple, l'apparition de charges électriques par effet pyroélectrique, ou bien la variation de la capacité par changement de la constante diélectrique, ou encore la variation de la résistance lorsque le matériau est semi-conducteur ou métallique.

Pour que de tels détecteurs fonctionnent de façon optimale, trois conditions principales sont nécessaires. Le matériau sensible doit avoir une faible masse calorifique, une bonne isolation thermique de sa couche active vis-à-vis de son support et une forte sensibilité de l'effet de conversion de l'échauffement en signal électrique, les deux premières conditions nécessitant une réalisation du matériau sensible en couche mince.

Dans de nombreuses applications, telles que des applications à l'imagerie infrarouge, les détecteurs thermiques doivent être conditionnés sous vide ou sous un gaz non conducteur de la chaleur pour gagner en performance. Dans ce cas, les détecteurs thermiques sont encapsulés dans un boîtier comportant une fenêtre transparente dans la bande III, c'est-à-dire la bande de 8 à 12 µm L'opération classique d'encapsulation en boîtier est délicate, en terme de rendement, et relativement coûteuse. Pour diminuer le coût de cette intégration, des méthodes d'encapsulation collective sont proposées.

Une de ces méthodes d' encapsulation collective est décrite dans le brevet WO-95/17014. Il s'agit d'une méthode d'encapsulation collective sous vide (ou sous un gaz non conducteur de .chaleur) par couplage d'une tranche de détecteurs avec une tranche de fenêtres transparentes au rayonnement infrarouge. La liaison entre les deux tranches est réalisée par un cordon de soudure qui, d'une part, assure l'étanchéité de l'ensemble et, d'autre part, permet le passage de la connexion électrique entre l'intérieur et l'extérieur du dispositif. Ce cordon de soudure détermine aussi, en fonction de son épaisseur, l'écartement entre les, deux composants du boîtier. L'écartement peut également être réalisé par une entretoise générée à partir de couchés déposées sur la tranche de dispositif ou la tranche de fenêtre, ou encore directement élaborée dans le matériau de la fenêtre. Pour des composants de grandes dimensions, un pilier peut être placé au centre, afin de limiter les déformations des' composants de grandes dimensions.

La méthode décrite dans ce document propose de placer une couche métallique du côté de la tranche de détecteurs et du côté de la tranche de fenêtres pour assurer la mouillabilité et l'accrochage de la soudure.

D'autre part, le maintien du vide à l'intérieur du microboîtier, est assuré en employant des matériaux qui ne présentent pas un taux de dégazage excessif. Cependant, même avec un taux de dégazage relativement faible, il est quasi obligatoire d'utiliser un matériau getter pour absorber les gaz émis par les différentes surfaces, car l'accroissement de la pression dégrade l'isolation thermique des microponts. Ce matériau getter peut être du baryum, du vanadium, du fer, du zirconium ou des alliages de ces matériaux. Cependant, avant, d'être actifs, de tels matériaux doivent être activés à haute température, pendant une courte période, soit par effet Joule, soit par un faisceau laser, sans toutefois que le détecteur et la fenêtre soient chauffés outre mesure. Pour résoudre ce problème, le matériau getter est déposé sur des microponts réservés à cet usage, ceci dans le but de confiner l'échauffement uniquement au matériau getter.

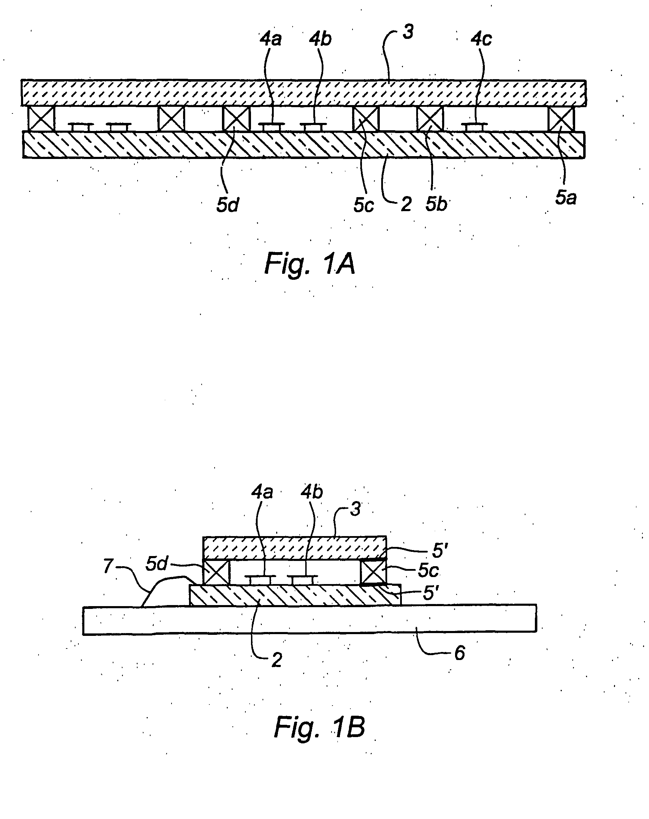

Sur la figure 1A, on a représenté schématiquement ce procédé de réalisation collective de dispositifs de détection infrarouge.

Cette figure 1A montre une tranche de détection 2, une tranche de fenêtres transparentes aux rayons infrarouges 3, et des microbolomètres, c'est-à-dire des détecteurs infrarouges non refroidis, référencés 4a, 4b, 4c. Cette figure 1A montre également que la tranche de détection 2 et la tranche de fenêtre 3. sont séparées à intervalles réguliers par des entretoises 5a, 5b, 5c, 5d, etc., qui assurent la séparation des différents dispositifs de détection.

L'ensemble représenté sur la figure 1A est ensuite'coupé entre deux entretoises, par exemple entre 5b et 5c, pour former différents dispositifs de détection infrarouge.

Par ailleurs, un dispositif de détection infrarouge à fenêtre en silicium est décrit dans la demande de brevet GB-A-2 310 952. Réaliser la fenêtre transparente aux rayons infrarouges, en silicium, présente des avantages, à savoir un coût peu élevé et une bonne compatibilité, en terme de coefficient de dilatation, avec le circuit de détection fabriqué également sur un substrat de silicium. En outre, le silicium permet d'obtenir un bon compromis entre les propriétés mécaniques et les propriétés optiques du dispositif.

Pour assurer l'assemblage de la fenêtre avec le circuit de détection, ce document propose d'effectuer soit un scellement eutectique, soit un scellement par verre fritté à bas point de fusion, soit une soudure par thermocompression. Dans le cas du scellement eutectique, il est proposé d'utiliser des alliages étain/plomb pour le scellement, et une tricouche W/Ni/Au pour les métallisations d'accrochage.

Sur la figure 1B, on a représenté schématiquement le dispositif de détection infrarouge décrit précédemment, après découpé à l'extérieur des entretoises 5c et 5d.

Ce dispositif de détection infrarouge comporte un circuit de détection comprenant les détecteurs 4a et 4b et des circuits de lecture, et une fenêtre transparente aux rayons infrarouges 3. La fenêtre 3 est maintenue au-dessus du circuit de détection 2 par l'intermédiaire de deux entretoises 5c et 5d. L'ensemble de ce dispositif est alors fixé sur un support 6, auquel il est connecté par des fils d'interconnexion 7.

Un tel dispositif nécessite des cordons de scellement 5' sur le circuit de détection 2, qui permettent le passage de la connexion électrique entre le circuit de détection 2 et les moyens de traitement extérieurs au dispositif, après isolation électrique de ces connexions. Or, l'introduction de tels cordons dans le procédé de réalisation est extrêmement délicate car elle nécessite la présence d' or, qui présente le risque de contaminer le circuit CMOS du circuit de détection 2.

De plus, ce cordon de scellement accroît la taille du circuit de détection qui constitue l'élément le plus onéreux du dispositif final. La topologie au niveau du joint de scellement 5' doit être considérablement réduite, c'est-à-dire qu'elle doit être planarisée, par polissage mécanochimique pour assurer un scellement hermétique.

En outre, comme expliqué précédemment, il est nécessaire d'utiliser des getters dans ce dispositif, afin d'assurer le maintien du vide à l'intérieur du dispositif, entre le circuit de détection 2 et la fenêtre 3. Or, ces getters sont placés à côté des détecteurs infrarouges, augmentant encore la surface du circuit de détection 2, au détriment du nombre de circuits de détection par tranche.

On connaît par l'abrégé (Patent Abstracts of Japan, Vol. 1998, No. 2, 30 janvier 1998) de la demande de brevet JP-A-09 264 784, un dispositif de détection de rayonnements électromagnétiques correspondant au préambule de la revendication 1.

Le document WO-A- 99/67818 divulgue un dispositif comprenant un support et un capot susceptible d'être scellé au support pour former avec le support une cavité à atmosphère contrôlée autour d'un composant. Un cordon d'étanchéité est formé autour du composant. Le dispositif comprend également des cales en matériau fusible électriquement conducteur. Elles peuvent assurer une liaison électrique entre le composant et la face externe du capot grâce à un trou d'interconnexion traversant le capot.

On connaît aussi par l'abrégé (Patent Abstracts of Japan, Vol. 1999, No. 10, 31 août 1998) de la demande de brevet JP-A-11 145 489, un capteur infrarouge comprenant un support pourvu d'une cavité fermée de manière étanche par un couvercle. Le support possède, au fond de la cavité, des électrodes en forme de bosses connectées à des électrodes de l'élément sensible du capteur et supportant l'élément sensible.

### Exposé de l'invention

L'invention a justement pour but de remédier aux inconvénients du dispositif et du procédé de réalisation décrits précédemment. A cette fin, elle propose un dispositif de détection de rayonnements infrarouges réalisé en trois dimensions, de façon à transférer la partie relative au scellement sur des éléments nettement moins coûteux que les circuits de détection et de façon à loger le getter en dessous du circuit de détection.

De façon plus précise, l'invention concerne un dispositif de détection de rayonnements électromagnétiques comprenant au moins un détecteur thermique non-refroidi et un circuit de lecture, le dispositif comportant :
- un substrat formant une cavité sous-vide, dans laquelle sont placés le détecteur thermique et le circuit de lecture ;
- une fenêtre transparente aux rayonnements, placée au-dessus de la cavité et assurant la fermeture de celle-ci ;
- des moyens de fermeture pour fermer hermétiquement la fenêtre sur le substrat ; et
- des moyens de connexion électrique assurant une connexion étanche entre le circuit de détection et des éléments de traitement extérieurs à la cavité;
caractérisé en ce que les moyens de connexion électrique traversent la fenêtre.

Avantageusement, le dispositif comporte un getter placé dans la cavité, en dessous du circuit de lecture.

Selon un mode de réalisation de l'invention, les moyens de connexion sont des orifices métallisés.

Selon un autre mode de réalisation de l'invention, les moyens de connexion sont des plots métalliques sensiblement en forme de H et traversant de part en part la fenêtre.

Dans une variante de l'invention, les moyens de fermeture consistent en un scellement anodique.

Dans une autre variante, les moyens de fermeture consistent en un scellement eutectique.

L'invention concerne également un procédé de réalisation de ce dispositif. Plus précisément, il s'agit d'un procédé d'encapsulation de détecteurs thermiques non refroidis, associés à au moins un circuit de lecture et destinés à détecter, des rayonnements électromagnétiques, consistant à :
a) réaliser une cavité dans un substrat ;
b) réaliser des orifices dans une fenêtre transparente aux rayonnements à détecter et insérer, de façon étanche, des moyens de connexion électrique dans les orifices de la fenêtre caractérisé en ce qu'il consiste en outre à :
c) connecter le circuit de détection à la fenêtre transparente par l'intermédiaire des moyens de connexion ; et
d) placer le circuit de détection dans la cavité et sceller hermétiquement la fenêtre transparente sur le substrat.

Avantageusement, le procédé de l'invention comporte une étape c', qui consiste à placer un getter dans la cavité, avant de placer le circuit de détection.

Avantageusement, on dépose une couche anti-reflet de part et d'autre de la fenêtre transparente.

Selon un mode de réalisation de l'invention, les détecteurs sont montés sur n circuits de lecture, avec n ≥ 2. Dans ce cas, le procédé de l'invention consiste à :
- réaliser n fois l'étape a) dans une tranche de substrats ;
- réaliser n fois l'étape b) dans une tranche de fenêtres transparentes ;
- réaliser n fois l'étape c) dans ladite tranche de fenêtres ;
- réaliser l'étape d) pour chaque cavité ; et
- découper l'ensemble formé de la tranche de fenêtre et de la tranche de substrat pour obtenir n dispositifs de détection conformes à celui de la revendication 1.

### Brève description des figures

- La figure 1A, déjà décrite, représente schématiquement l'étape générale du procédé de fabrication collective du dispositif de l'art antérieur ;
- la figure 1B représente le dispositif de l'art antérieur obtenu par le procédé de la figure 1A ;
- la figure 2 représente le dispositif de détection de rayonnements infrarouges de l'invention ; et
- la figure 3 représente schématiquement les différentes étapes de réalisation du dispositif de la figure 2.

### Description détaillée de modes de réalisation de l'invention

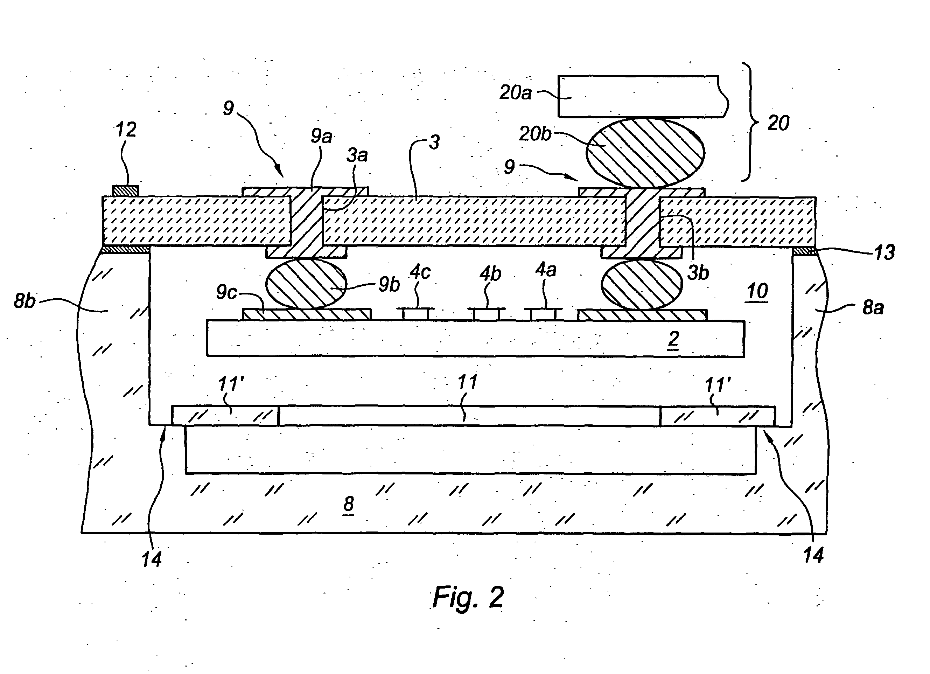

Sur la figure 2, on a représenté schématiquement le dispositif de détection de rayonnements infrarouges selon l'invention. Les références portées sur la figure 2, qui sont similaires à celles portées sur les figures 1A et 1B, représentent des éléments identiques.

Le dispositif de l'invention se présente sous la forme d'un empilement d'éléments dans trois dimensions. L'un de ces éléments est un circuit de détection 2, qui comporte un circuit de lecture et trois détecteurs infrarouges non refroidis 4a, 4b et 4c, qui sont appelés aussi « microponts » et qui sont connectés au circuit de lecture. Le nombre de détecteurs peut être élevé (par exemple 256 x 256).

Lorsque le dispositif de détection est appliqué à l'imagerie infrarouge, chaque micropont représente un pixel de l'image détectée.

Le circuit de détection 2 est placé à l'intérieur d'un substrat 8 creusé de façon à former une cavité 10.

Un autre élément de l'empilement 3D est une fenêtre transparente aux rayonnements infrarouges, référencée 3, et placée au-dessus de la cavité 10, de façon à assurer la fermeture de la cavité 10. Cette fenêtre transparente 3 repose sur les parois 8a et 8b de la cavité 10. Elle est fixée sur ces parois, par un scellement, par exemple de type anodique, comme représenté par la référence 12 sur la figure 2. Cette fenêtre 3 peut également être fixée sur les parois de la cavité 10 par un scellement de type eutectique, comme représenté par la référence 13. On comprendra, bien sûr, que lors de la réalisation d'un tel dispositif, on réalise le scellement de la fenêtre sur le substrat 8 (c'est-à-dire sur les parois 8a et 8b de la cavité 10) par un même type descellement, à savoir un scellement anodique ou un scellement eutectique.

La fenêtre transparente 3 est percée de plusieurs orifices laissant traverser les moyens de connexion entre l'extérieur du dispositif et l'intérieur de la cavité.

Dans le mode de réalisation de la figure 2, la fenêtre transparente aux rayons infrarouges comprend deux orifices, référencés 3a et 3b, permettant le passage des moyens de connexion 9 à travers la fenêtre 3. Les orifices peuvent être métallisés par un procédé de sérigraphie ou bien par décomposition thermique (procédé LPCVD). De préférence, l'épaisseur de ces couches métallisées est comprise entre 0,5 µm et 5 µm.

Les moyens de connexion 9 assurent le maintien du circuit de détection 2 à l'intérieur de la cavité 10.

Ils assurent, par conséquent, le positionnement des détecteurs infrarouges 4a, 4b et 4c par rapport à la fenêtre. Ces moyens de connexion 9 permettent, d'autre part, le passage étanche d'une connexion électrique étanche entre le circuit de détection 2 contenu dans la cavité 10 et des moyens de traitement 20 extérieurs au dispositif. Ces moyens de traitement électronique extérieurs 20 peuvent être, par exemple, une carte électronique 20a connectée, par l'intermédiaire de plots de soudure 20b, à un ou plusieurs moyens de connexion 9 du dispositif de détection.

Les moyens de connexion électrique 9 peuvent être de différents types. Toutefois, il est nécessaire que ces moyens de connexion soient suffisamment rigides pour permettre la fixation mécanique du circuit de détection 2, afin d'assurer une position stable à ce circuit à l'intérieur de la cavité et qu'ils soient étanches de façon à assurer le vide à l'intérieur de la cavité 10. Il est à noter que l'on parlera, dans toute la description et les revendications, de « cavité sous vide », étant entendu qu'il peut s'agir aussi d'un gaz peu conducteur de chaleur.

Ces moyens de connexion 9 peuvent, par exemple, consister en des plots métalliques 9a ayant sensiblement une forme de H renversé et traversant de part en part la fenêtre (ils seront appelés, par la suite, plots métalliques en H). Mais toute technique utilisant des trous métallisés totalement ou partiellement comblés peut aussi convenir.

Ces moyens de connexion comportent également des plots métalliques de connexion 9c, fixés sur le circuit de détection 2 (appelés plots métalliques plats). Des plots d'hybridation, référencés 9b, assurent le lien mécanique et la connexion électrique entre les plots métalliques en H 9a et les plots métalliques plats 9c. Ces plots 9a, 9b et 9c sont réalisés en des matériaux métalliques, tels que du Ti, TiN, Pt, Al, Au, W, Ni, Ln, Sn, MnPb, SnPb, etc.. Ils sont déposés sur le dispositif par pulvérisation cathodique, CVD, ou bien par procédé d'évaporation.

Le dispositif de l'invention présente l'avantage de comporter une cavité suffisamment profonde pour permettre d'installer un getter à l'intérieur du dispositif, sous le circuit de détection 2. Sur la figure 2, on a représenté un getter 11, placé sur un support de getter 11', éventuellement thermiquement isolant, en appui sur des décrochements 14 réalisés dans les parois 8a et 8b de la cavité. Le getter ainsi placé en dessous du circuit de lecture 2, permet un gain de place considérable par rapport aux dispositifs classiques dans lesquels le getter est placé à côté du circuit de lecture. Le getter peut ainsi être de grande dimension et donc être utilisé comme micropompe, c'est-à-dire qu'il peut remplacer partiellement un dispositif de pompage secondaire, en général extérieur à l'ensemble à pomper.

En outre, cet emplacement du getter, en regard de la face arrière du circuit de lecture 2, évite les risques d'altération des détecteurs 4a, 4b, 4c lors du scellement, puisque le getter n'est pas en contact direct avec le circuit de détection.

Dans le dispositif de l'invention, le scellement de la fenêtre 3 sur le substrat 8 peut être un scellement anodique ; celui-ci implique l'utilisation de verre, de type PYREX^{®} (borosilicate), fortement dopé avec du sodium ou du potassium. L'ensemble à encapsuler est alors placé sous vide à une température, comprise typiquement entre 100 et 500°C, et en présence d'un champ électrique élevé, de l'ordre de 7 x 10⁶ V/m dans le verre. La durée de l'opération peut -atteindre, 30 minutes environ. Or, sous l'effet conjugué du champ électrique et de la température, les ions migrent vers l'anode et la cathode où ils sont piégés. Les ions, ainsi accumulés, créent un champ électrique interne important qui assure l'adhésion des deux matériaux en présence. Toutefois, il est connu que les circuits CMOS (comme c'est le cas pour le circuit de lecture) sont sensibles à la diffusion de tels ions métalliques et au fort champ électrique. Mais, dans l'invention, le circuit de détection 2 est « suspendu » dans la cavité par l'intermédiaire des moyens de connexion 2 ; le scellement anodique se fait donc entre la fenêtre 3 et les parois 8a et 8b de la cavité 10, sans risque de toucher le circuit de détection 2. Ainsi, le champ électrique nécessaire au scellement est confiné à l'extérieur du circuit de détection ; il ne risque donc pas de le dégrader.

Dans le dispositif de l'invention, il est également possible de sceller la fenêtre 3 sur le substrat 8 par un scellement eutectique. Ce type de scellement consiste à introduire une couche métallique, par exemple de l'or, entre deux surface's de silicium, c'est-à-dire une couche d'or 13 entre la fenêtre et les parois de la cavité, puis à chauffer l'ensemble. La température de fusion du mélange qui se forme par diffusion est plus' faible que celle du métal ou du silicium. Ainsi, l'or réagit avec le silicium à 363°C pour former l'eutectique AuSi.

Dans le dispositif de l'invention, le circuit de détection n'est jamais directement en contact avec le métal, par exemple l'or, utilisé pour le scellement. Il n'y a donc aucun risque de contamination du circuit de détection par l'or.

En outre, dans ce dispositif, il n'y a aucun relief provenant de métallisation, c'est-à-dire de contacts métalliques traversant le cordon de scellement pour aller vers l'extérieur. Le scellement eutectique peut donc être réalisé sans problème entre la fenêtre et les parois de la cavité.

Le scellement de la fenêtre sur les parois de la cavité peut aussi se faire à partir de verres à bas point de fusion ou bien de colles ou encore par apport de brasure.

Pour réaliser le dispositif de l'invention, il est nécessaire d'activer le getter, ce qui consiste à le chauffer. Le chauffage peut être réalisé par le passage d'un courant électrique ou bien par le chauffage de 'l'ensemble substrat/fenêtre, ou avantageusement par laser. Cette activation laser est réalisée à travers le substrat qui doit être transparent autour de la longueur d'onde de fonctionnement du laser. L'utilisation d'un laser balayé permet d'activer la surface maximum du getter 11, tout en évitant de trop chauffer les détecteurs thermiques. A cet égard, la face arrière du circuit de détection peut être munie d'une couche réfléchissant la lumière infrarouge émise par le getter lors de son activation. Le support 11' du getter est alors réalisé dans un matériau thermiquement isolant. Ce procédé d'activation au laser permet d'atteindre une température supérieure à 500°C et, ainsi, d'obtenir une période d'activation de quelques minutes seulement.

L'activation peut également se faire par radiofréquence. Dans ce cas, le matériau constituant le getter 11 ou son support 11' peut être métallique. On effectue alors un chauffage par induction à partir de la face arrière du substrat formant la cavité. Ainsi, une onde électromagnétique provoque la circulation de courants induits, qui engendrent, à leur tour, des pertes par effet Joule dues au courant de FOUCAULT. Afin de ne pas dégrader le circuit de détection pendant la phase d'activation, l'épaisseur du getter et/ou de son support doit être adaptée de manière à réaliser un blindage efficace. Comme pour l'activation par laser, la face arrière du circuit de détection peut comporter une couche réfléchissante, de préférence non conductrice de l'électricité.

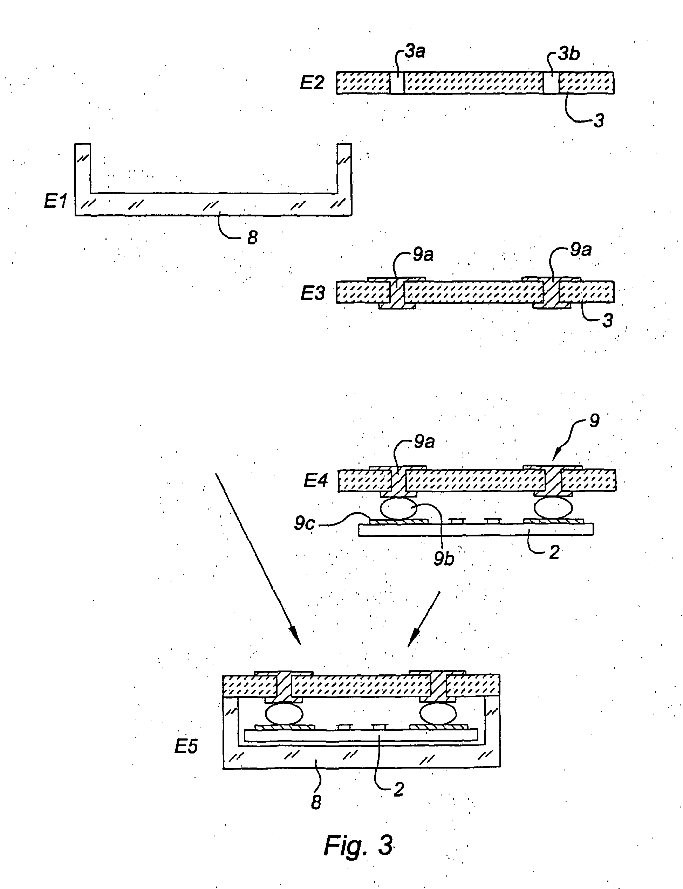

Le dispositif de l'invention, tel que décrit précédemment, peut être réalisé au moyen d'un procédé, dit « d'encapsulation des détecteurs thermiques non refroidis ». Comme représenté sur la figure 3, ce procédé consiste, tout d'abord, à réaliser une cavité 10 dans un substrat 8 (étape E1), ce substrat étant, par exemple, :en silicium ou en verre. Il consiste ensuite (étape E2) à réaliser des orifices 3a, 3b dans une fenêtre transparente aux rayons infrarouges ; cette fenêtre peut être, par exemple, en silicium ou bien en germanium ou encore en ZnS. Son épaisseur dépend de sa nature et du format des détecteurs. Elle est comprise, de préférence, entre 100 µm et 2 mm.

Des moyens de connexion 9 sont ensuite insérés dans les orifices de la fenêtre (étape E3), de façon à permettre une connexion étanche.

Ensuite, le circuit de détection 2 est connecté sur la fenêtre transparente 3 par l'intermédiaire des moyens de connexion 9 (étape E4). Le circuit de détection 2 ainsi fixé sur la fenêtre 3 est alors inséré dans la cavité 10 (étape E5). La fenêtre transparente 3 est scellée hermétiquement sur les parois 8a et 8b du substrat.

Dans le mode de réalisation préféré' de l'invention, le procédé consiste à placer un getter 11 dans la cavité', par exemple en appui sur des décrochements 14 réalisés dans la cavité, et ce avant de placer le circuit de lecture. Le getter peut aussi être réalisé directement dans le substrat au moment où ce dernier est élaboré pour former la cavité. Une étape supplémentaire permet de réaliser un anti-reflet sur la fenêtre, par dépôt d'une couche anti-reflet de part et d'autre de la fenêtre transparente.

Le détecteur de l'invention peut également être réalisé, de manière collective. Plusieurs dispositifs sont alors réalisés simultanément. Dans ce cas, il est nécessaire d'avoir réalisé au préalable :
- une tranche de détection (circuits de détection) sur laquelle est connectée une pluralité de détecteurs infrarouges non refroidis et leur circuit de lecture ;
- une tranche de fenêtres infrarouges réalisées en Si, Ge ou ZnS, avec des connexions vers l'extérieur ; et
- une tranche de substrat avec des cavités et des getter.

La tranche de fenêtres et la tranche de substrats ont été préalablement élaborées, de façon séparée, en utilisant des techniques de microélectronique classiques. Autrement dit, les cavités dans la tranche de substrats et les orifices dans la tranche de fenêtres sont réalisés par des procédés de gravure chimique ou de gravure par plasma.

Ainsi, lorsque la tranche de fenêtre et la tranche de substrats ont été élaborées, on hybride la tranche de détection sur'la tranche de fenêtre, qui a pu être préalablement traitée anti-reflet. Ensuite, les composants de la tranche de détection sont séparés par des moyens classiques de découpe des circuits intégrés sur tranche. Le procédé de réalisation collectif consiste alors à placer les getters à l'intérieur des cavités et à sceller hermétiquement la tranche de fenêtres sur laquelle est fixée la tranche de détection avec la tranche de substrats. Ce scellement peut se faire selon l'une des techniques décrites précédemment.

On effectue ensuite la découpe de l'ensemble en une seule passe. L'activation du getter peut être' effectuée avant ou après découpe, de sorte qu'à l'issue de la phase d'activation, la pression résiduelle dans la cavité soit inférieure à 10 mTorr (= 10⁻² mbar).

Selon une variante, il est possible, pour augmenter le nombre de circuits de détection par tranche de substrat, de découper la tranche de circuits de détection et connecter collectivement les circuits de détection ainsi obtenus à la tranche de fenêtre et ensuite seulement de reporter, puis de sceller l'ensemble sur la tranche de substrat.

## Revendications

1. Dispositif de détection de rayonnements électromagnétiques comprenant au moins un circuit de détection comprenant un détecteur thermique non-refroidi (4) et un circuit de lecture associé (2), le dispositif comportant :
- un substrat (8) formant une cavité sous vide (10), dans laquelle sont placés le détecteur thermique et le circuit de lecture ;
- une fenêtre (3) transparente aux rayonnements, placée au-dessus de la cavité et assurant la fermeture de celle-ci ;
- des moyens de fermeture (12, 13) pour fermer hermétiquement la fenêtre sur le substrat ; et
- des moyens de connexion électrique (9) assurant une connexion étanche entre le circuit de détection et des éléments de traitement extérieurs à la cavité;
**caractérisé en ce que** les moyens de connexion électrique (9) traversent la fenêtre.

2. Dispositif selon la revendication 1, **caractérisé en ce qu'**il comporte un getter (11) placé dans la cavité, en dessous du circuit de lecture.

3. Dispositif selon l'une quelconque des revendications 1 et 2, **caractérisé en ce que** les moyens de connexion sont des orifices métallisés (3a).

4. Dispositif selon l'une quelconque des revendications 1 et 2, **caractérisé en ce que** les moyens de connexion sont des plots métalliques (9a) sensiblement en forme de H, traversant de part en part la fenêtre.

5. Dispositif selon les revendications 1 à 4, **caractérisé en ce que** les moyens de fermeture consistent en un scellement anodique (12).

6. Dispositif selon les revendications 1 à 4, **caractérisé en ce que** les moyens de fermeture consistent en un scellement eutectique (13).

7. Procédé d'encapsulation de détecteurs thermiques non-refroidis associés à au moins un circuit de lecture (2) et destinés à détecter des rayonnements électromagnétiques, consistant à :
a) réaliser (E1) une cavité (10) dans un substrat (8);
**caractérisé en ce qu'**il consiste on outre à :
b) réaliser (E2) des orifices (3a, 3b) dans une fenêtre (3) transparente aux rayonnements à détecter et insérer (E3), de façon étanche, des moyens de connexion électrique (9) dans les orifices de la fenêtre,
les moyens de connexion électrique (9) traversant ainsi la fenêtre;
c) connecter (E4) le circuit de détection (114) à la fenêtre transparente, (13) par l'intermédiaire des moyens de connexion (9);
d) placer (E5) le circuit de détection (4) dans la cavité (10) et sceller hermétiquement la fenêtre transparente sur le substrat.

8. Procédé selon la revendication 7, **caractérisé en ce qu'**il comporte une étape c') qui consiste à placer un getter dans la cavité, avant de placer le circuit de détection.

9. Procédé selon la revendication 7 ou 8, **caractérisé en ce qu'**il consiste à déposer une couche anti-reflet de part et d'autre de la fenêtre transparente.

10. Procédé selon l'une quelconque des revendications 7 à 9, dans lequel les détecteurs sont associés à n circuits de lecture, avec n ≥ 2, **caractérisé en ce qu'**il consiste à :
- réaliser n fois l'étape a) dans une tranche de substrat ;
- réaliser n fois l'étape b) dans une tranche de fenêtre transparente ;
- réaliser n fois l'étape c) dans ladite tranche de fenêtre ;
- réaliser, l'étape d) pour chaque cavité ; et
- découper l'ensemble constitué de la tranche de fenêtre et de la tranche de substrat pour obtenir n dispositifs de détection conformes à celui de la revendication 1.

## Claims

1. Device for detecting electromagnetic radiation comprising at least one detection circuit comprising a non-cooled thermal detector (4) and an associated reading circuit (2), said device comprising:
- a substrate (8) forming a cavity under vacuum (10), in which are placed the thermal detector and the reading circuit;
- a window (3) transparent to radiation, placed above the cavity and ensuring the sealing of said cavity;
- sealing means (12, 13) for hermetically sealing the window on the substrate; and
- electrical connection means (9) ensuring a leaktight connection between the detection circuit and the processing elements outside the cavity;
**characterized in that** the electrical connection means (9) pass through the window.

2. Device according to claim 1, **characterized in that** it comprises a getter (11) placed in the cavity, below the reading circuit.

3. Device according to either of claims 1 and 2, **characterized in that** the connection means are metallised apertures (3a).

4. Device according to either of claims 1 and 2, **characterized in that** the connection means are metallic contact plates (9a), substantially in the form of an H, passing right through the window.

5. Device according to claims 1 to 4, **characterized in that** the sealing means consists in an anodic sealing (12).

6. Device according to claims 1 to 4, **characterized in that** the sealing means consists in an eutectic sealing (13).

7. Method for encapsulating non-cooled thermal detectors combined with at least one reading circuit (2) and intended to detect electromagnetic radiation, consisting of:
a) forming (E1) a cavity (10) in a substrate (8);
**characterized in that** it also consists of:
b) forming (E2) apertures (30, 36) in a window (3) transparent to the radiation to be detected and inserting (E3), in a leaktight manner, electrical connection means (9) in the apertures of the window, the electrical connection means (9) thus passing through the window;
c) connecting (E4) the detection circuit (14) to the transparent window (13) through the connection means;
d) placing (E5) the detection circuit (14) in the cavity (10) and hermetically sealing the transparent window on the substrate.

8. Method according to claim 7, **characterized in that** it comprises a step c) that consists in placing a getter in the cavity, before putting in place the detection circuit.

9. Method according to claim 7 or 8, **characterized in that** it consists in depositing an anti-reflection layer on either side of the transparent window.

10. Method according to any of claims 7 to 9, in which the detectors are associated with n reading circuits, where n ≥ 2, **characterized in that** it consists in:
- carrying out n times step a) in a wafer of substrate;
- carrying out n times step b) in a wafer of transparent window;
- carrying out n times step c) in said window wafer;
- carrying out step d) for each cavity; and
- cutting the assembly comprising the wafer of window and the wafer of substrate in order to obtain n detection devices conforming to the detection device of claim 1.

## Patentansprüche

1. Vorrichtung zur Detektion von elektromagnetischer Strahlung, die wenigstens eine Detektionsschaltung mit einem ungekühlten Wärmedetektor (4) und eine zugeordnete Leseschaltung (2) umfasst, wobei die Vorrichtung umfasst:
- ein Substrat (8) mit einem Hohlraum (10) unter Vakuum, in dem der Wärmedetektor und die Leseschaltung angeordnet sind;
- ein für Strahlungen transparentes Fenster (3), das sich über dem Hohlraum befindet und diesen verschließt;
- Verschlusseinrichtungen (12, 13), um das Fenster auf dem Hohlraum hermetisch abzudichten; und
- elektrische Verbindungseinrichtungen (9), die eine dichte Verbindung zwischen der Detektionsschaltung und außerhalb des Hohlraums befindlichen Verarbeitungselementen gewährleisten;
**dadurch gekennzeichnet, dass** die elektrischen Verbindungseinrichtungen (9) das Fenster durchqueren.

2. Vorrichtung nach Anspruch 1, **dadurch gekennzeichnet, dass** sie einen Getter (11) umfasst, angeordnet in dem Hohlraum, unter der Leseschaltung.

3. Vorrichtung nach einem der Ansprüche 1 und 2, **dadurch gekennzeichnet, dass** die Verbindungseinrichtungen metallisierte Öffnungen (3a) sind.

4. Vorrichtung nach einem der Ansprüche 1 und 2, **dadurch gekennzeichnet, dass** die Verbindungseinrichtungen im Wesentlichen H-förmige, das Fenster durchquerende Metallstücke (9a) sind.

5. Vorrichtung nach den Ansprüchen 1 bis 4, **dadurch gekennzeichnet, dass** die Verschlusseinrichtungen durch eine anodischen Verschmelzung (12) gebildet werden.

6. Vorrichtung nach den Ansprüchen 1 bis 4, **dadurch gekennzeichnet, dass** die Verschlusseinrichtungen durch eine eutektische Verschmelzung (13) gebildet werden.

7. Verfahren zur Einkapselung von ungekühlten Wärmedetektoren, die wenigstens einer Leseschaltung (2) zugeordnet und dazu bestimmt sind, elektromagnetische Strahlungen zu detektieren, darin bestehend:
a) einen Hohlraum (10) in einem Substrat (8) zu realisieren (E1), und **dadurch gekennzeichnet, dass** es außerdem darin besteht:
b) Öffnungen (3a, 3b) in einem für die zu detektierende Strahlung transparenten Fenster zu realisieren (E2), und auf dichte Weise in den Öffnungen des Fensters elektrische Verbindungseinrichtungen (9) zu realisieren (E3), wobei also die elektrischen Verbindungseinrichtungen (9) das Fenster durchqueren,
c) die Detektionsschaltung (4) durch Verbindungseinrichtungen (9) mit dem transparenten Fenster (13) zu verbinden (E4),
d) die Detektionsschaltung (4) in dem Hohlraum (10) zu platzieren und das transparente Fenster und das Substrat durch Verschmelzung hermetisch zu verschließen (E5).

8. Verfahren nach Anspruch 7, **dadurch gekennzeichnet, dass** es einen Schritt c') umfasst, der darin besteht, einen Getter in dem Hohlraum zu platzieren, vor der Platzierung der Detektionsschaltung.

9. Verfahren nach Anspruch 7 oder 8, **dadurch gekennzeichnet, dass** es darin besteht, auf beiden Seiten des transparenten Fensters eine Antireflexschicht abzuscheiden.

10. Verfahren nach einem der Ansprüche 7 bis 9, bei dem die Detektoren n Leseschaltungen zugeordnet sind, mit n ≥ 2,
**dadurch gekennzeichnet, dass** es darin besteht:
- in einer Substratscheibe n-mal den Schritt a) zu realisieren;
- in einer transparenten Fensterscheibe n-mal den Schritt b) zu realisieren;
- in der genannten Fensterscheibe n-mal den Schritt c) zu realisieren;
- für jeden Hohlraum den Schritt d) zu realisieren; und
- das durch die Fensterscheibe und die Substratscheibe gebildete Ganze so zu zerschneiden, dass man n Detektionsvorrichtungen gemäß derjenigen des Anspruchs 1 erhält.
